# EUROPEAN PATENT SPECIFICATION

(11) **EP 3 544 121 B1**
(45) Date of publication and mention of the grant of the patent: **04.05.2022**
(21) Application number: 18162576.5
(22) Date of filing: 19.03.2018
(51) Int. Cl.: H01R 12/58, H05K 3/40, F24H 9/18

(54) **ELECTRICAL HEATING DEVICE**
ELEKTRISCHE HEIZVORRICHTUNG
DISPOSITIF DE CHAUFFAGE ÉLECTRIQUE

(43) Date of publication of application: 25.09.2019
(73) Proprietor: Mahle International GmbH, 70376 Stuttgart (DE)
(72) Inventor: MAGNIER, Gilles, 90110 Rougemont-le-Chateau (FR)
(74) Representative: BRP Renaud & Partner mbB Rechtsanwälte Patentanwälte Steuerberater

(56) References cited:
- EP-A1- 2 615 696
- EP-A2- 1 431 992
- WO-A1-2016/128756
- KR-A- 20120 140 088
- US-A- 3 964 813
- Eberspächer Uk: "HV coolant heater technical sales notes generation 3", , 31 October 2017 (2017-10-31), pages 1-2, XP055507365, Retrieved from the Internet: URL:https://www.eberspacher.com/fileadmin/ data/countrysites/EB_UK/pdf_files/info_pdf _ebuk/electric_pdf_ebuk/hv_gen3_coolant_he ater_ebuk_jn1108.pdf [retrieved on 2018-09-17]

## Description

The invention relates to an electrical heating device comprising a heating element and comprising a control board according to the preamble of claim 1.

Electrical heating devices are already known from the prior art and usually have a heating element and a control board for controlling the heating element. The heating element is thereby electroconductively connected to the control board via at least one electrical conductor. For this purpose, the conductor of the heating element can be soldered to the control board or can be connected to the control board via a connector plug. In the alternative, the heating element can be pressure-connected to the control board via at least one pin, as is described for example in EP 2 236 330 A1. WO 2016/128756 A1 discloses an electrical motor which is pressure-connected to the control board via a connector. For this case, the control board has a plurality of contact bushing and the connector has a plurality of contact pins. EP 1 431 992 A2 and EP 2 615 696 A1 disclose similar connectors with contact pins pressure-connected to contact bushings at the control board. KR 2012 014 0088 A discloses a high voltage PTC-heater with terminals which extend through the control board and are connected to the anode and to the cathode on the opposite sides of the control board.

The experts always strive to design the heating devices in a more compact and space-saving manner. Due to the fact that in particular the contact of the heating element to the control board requires an increased installation space, this contact is to be designed as compactly as possible. The production costs are to further be reduced as well.

It is thus the object of the invention to specify an improved or at least an alternative embodiment for a heating device of the generic type, in which the described disadvantages are overcome.

According to the invention, this object is solved by means of the subject matter of independent claim 1. Advantageous further embodiments are the subject matter of the dependent claims.

A generic electrical heating device has a heating element and a control board. The heating element is electroconductively connected to the control board via at least one electrical contact pin, and the control board has a contact arrangement comprising at least one contact bushing, which penetrates the control board. The at least one contact pin thereby penetrates the control board through the at least one contact bushing and is electroconductively pressure-connected to the contact bushing. The heating element is a PTC resistor heating element which can be operated at a voltage of equal to 400 V or 800 V. According to the invention, a length of the at least one contact bushing is smaller than or equal to a thickness of the control board and the contact bushing is arranged completely inside the control board. An additional installation space need in height direction/thickness direction of the control board can be avoided through this and a compact construction can be attained through this.

The at least one contact pin is pressure-connected to the control board via the contact bushing of the contact arrangement. For this purpose, the at least one contact pin penetrates the control board by means of the at least one contact bushing. The contact bushing can thereby be - for example clamped - in the control board in a non-positive manner - or can for example be adhesively bonded therein - by means of a substance-to-substance bond. According to the invention, the contact bushing is arranged completely in the control board, so that the required space for the contact arrangement on the control board is reduced. The dimensions of the control board can thus be reduced in an advantageous manner. The contact arrangement can further also be constructed more compactly, whereby the heating device as a whole can be constructed in a more space-saving manner.

Provision can advantageously be made for the at least one contact bushing to have a radial collar each on both sides. The respective radial collar is thereby flush with a board surface of the control board. The respective radial collars can support the contact bushing in the control board on both sides, so that, when establishing or when releasing the electroconductive contact between the at least one contact pin and the at least one contact bushing, the latter remains securely mounted in the control board. The radial bearing is thereby flush with the board surface of the control board, so that the required space for the contact bushing and for the contact arrangement as a whole is reduced. The at least one contact bushing of the contact arrangement and/or the at least one contact pin of the heating element can be formed of metal, preferably of aluminum.

To mount the at least one contact pin in the at least one contact bushing so as to be pressure-connected, the at least one contact pin can have at least one radially protruding press protrusion. The at least one press protrusion then deforms elastically at least area by area in the at least one contact bushing and mounts the contact pin in the contact bushing by means of a radial pressing force. The press protrusion thereby protrudes radially outwards from the respective contact pin and can extend for example axially on the respective contact pin. A length of the press protrusion can thereby be longer than the length of the contact bushing, so that the contact pin can be mounted securely in the contact bushing. The press protrusion can further have a ramp area, which increases steadily from zero to a height of the press protrusion. The radial pressing force in response to establishing the electroconductive contact between the respective contact pin and the contact bushing can thus increase steadily and the electroconductive contact can be established and released more easily.

In the alternative or in addition, the at least one contact pin can have a hollow space, which is radially encompassed by a pressing wall. The pressing wall then deforms elastically at least area by area in the contact bushing and mounts the at least one contact pin in the contact bushing by means of a radial pressing force. In this advantageous embodiment of the contact pin, the radial pressing force between the contact pin and the contact bushing is directed radially to the outside on all sides, so that the contact pin can be mounted securely in the contact bushing. The contact pin can thereby have an adapted form - for example a diameter, which increases towards the heating element. The radial pressing force in response to establishing the electroconductive contact between the respective contact pin and the contact bushing can thus increase steadily and the electroconductive contact can be established and released more easily.

To be able to axially mount the contact pin in the contact bushing, the at least one contact bushing can have at least one fitting molding, which is directed radially to the outside. The at least one contact pin comprising the press protrusion and/or comprising the pressing wall, can be mounted in a positive manner at least area by area in the fitting molding. When establishing the electroconductive contact, the contact pin can be axially mounted in a secure manner in this way and the electroconductive contact can thus be established more easily as well.

Provision can advantageously be made for the contact arrangement to have a plurality of conductor tracks, which are electroconductively connected to the at least one contact bushing. The at least one contact bushing can then be electroconductively connected to control elements of the control board by means of the conductor tracks. The conductor tracks can be integrally molded on the contact bushing or can be mounted thereto by means of a substance-to-substance bond - for example soldered. Advantageously, the conductor tracks of the contact arrangement can be integrated into the control board and can be enclosed by the latter at least area by area. The required space for the contact arrangement on the control board can in particular be reduced by this. In the alternative or in addition, the conductor tracks of the contact arrangement can be mounted to the control board. The plurality of conductor tracks of the contact arrangement can be formed of metal, preferably of aluminum.

According to the invention, the heating element is the PTC resistor heating element, which can be operated at a voltage of equal to 400 V or 800 V. A plurality of PTC resistors are electrically interconnected in a PTC resistor heating element. In response to a high voltage of equal to 400 V or 800 V, the PTC resistor heating element regulates down to a low current, so that the transition resistance between the contact bushing and the contact pin remains low and the at least one contact pin comprising the at least one contact bushing can be pressure-controlled securely in an electroconductive manner.

In summary, the required installation space for producing the electroconductive contact between the contact pin and contact bushing in the heating device according to the invention can be reduced at the control board and also in the heating device. The heating device according to the invention can thus be constructed more compactly.

Further important features and advantages of the invention follow from the subclaims, from the drawings, and from the corresponding figure description by means of the drawings.

It goes without saying that the above-mentioned features and the features, which will be described below, cannot only be used in the respective specified combination, but also in other combinations or alone, without leaving the scope of the present invention.

Preferred exemplary embodiments of the invention are illustrated in the drawings and will be described in more detail in the description below, whereby identical reference numerals refer to identical or similar or functionally identical components.

In each case schematically,
- Fig. 1: shows a sectional view of a contact pin and of a contact bushing in an electrical heating device according to the invention;
- Fig. 2: shows a view of a control board comprising contact pins penetrating it in an electrical heating device according to the invention;
- Fig. 3: shows a sectional view of a contact pin and of a contact bushing in an electrical heating device according to the invention;
- Fig. 4: shows a view of a plurality of contact pins in an electrical heating device according to the invention.

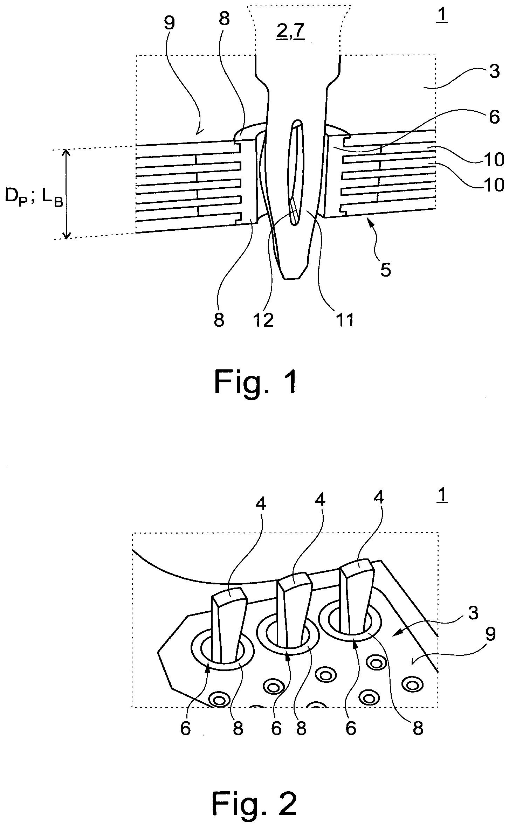

Fig. 1 shows a sectional view of an electrical heating device 1 according to the invention. The heating device 1 has a heating element 2- only suggested here - and a control board 3. The heating element 2 is electroconductively connected to the control board 3 via at least one electrical contact pin 4. For this purpose, the control board 3 has a contact arrangement 5 comprising at least one contact bushing 6, which penetrates the control board 3. According to the invention, a length L_{B} of the at least one contact bushing 6 is smaller than or equal to - in this exemplary embodiment equal to - a thickness Dp of the control board 3 and the at least one contact bushing 6 is arranged completely inside the control board 3. The required space for the contact arrangement 5 on the control board 3 and the dimensions of the control board 3 can thus be reduced in an advantageous manner and the heating device 1 as a whole can be constructed more compactly.

The at least one contact pin 4 penetrates the control board 3 through the at least one contact bushing 6 and is pressure-connected in an electroconductive manner by means of the at least one contact bushing 6. The heating element 2 is thus also electrically connected to the control board 3 and can be controlled by the latter. The heating element 2 is a PTC resistor heating element 7, which can be operated at a voltage of equal to 400 V or 800 V. In response to a high voltage of equal to 400 V or 800 V, the PTC resistor heating element 7 regulates down to a low current, so that the transition resistance between the contact bushing 6 and the contact pin 4, which is pressure-connected therewith, remains low.

The at least one contact bushing 6 in each case has a radial collar 8 on both sides. The respective radial collar 8 is thereby arranged so as to be flush with a board surface 9 of the control board 3. The respective radial collars 8 support the at least one contact bushing 6 in the control board 3 on both sides, so that, when repeatedly establishing or when repeatedly releasing the electroconductive contact between the at least one contact pin 4 and the at least one contact bushing 6, the latter remains securely mounted in the control board 3. The required space for the at least one contact bushing 6 and for the contact arrangement 5 as a whole is reduced.

The contact arrangement 5 has a plurality of conductor tracks 10, which are electroconductively connected to the at least one contact bushing 6. The at least one contact bushing 6 can be electroconductively connected to control elements - not shown here - of the control board 3 by means of the conductor tracks 10. In this exemplary embodiment, the conductor tracks 10 are embodied integrally on the at least one contact bushing and are integrated into the control board 3 and are enclosed by the latter at least area by area. The required space on the control board 3 is thus additionally reduced. The at least one contact bushing 6 and the conductor tracks 10 of the contact arrangement 3 as well as the at least one contact pin 4 of the heating element 2 are formed of metal, preferably of aluminum.

To mount the at least one contact pin 4 in the at least one contact bushing 6 in a pressure-connected manner, the at least one contact pin 4 has a hollow space 12, which is radially compassed by a pressing wall 11, in this exemplary embodiment. The pressing wall 11 deforms elastically at least area by area in the at least one contact bushing 6 and thus mounts the at least one contact pin 4 in the at least one contact bushing 6 by means of a radially acting pressing force. The at least one contact pin 4 has a diameter, which increases to a constant value towards the heating element 2. The radially acting pressing force between the at least one contact pin 4 and the at least one contact bushing 6 in response to establishing the electroconductive contact between the at least one contact pin 4 and the at least one contact bushing 6 can thus increase steadily and the electroconductive contact can be established and released more easily.

Fig. 2 shows a view of the control board 3 comprising the contact arrangement 5. In this exemplary embodiment, the contact arrangement 5 has three contact bushings 6, which are arranged next to one another on the control board 3. Three contact pins 4 of the heating element 2 are mounted in the contact bushings 6 of the contact arrangement 5. The contact pins 4 thereby penetrate the control board 3 through the contact bushings 6 and are pressure-connected with the contact bushings 6.

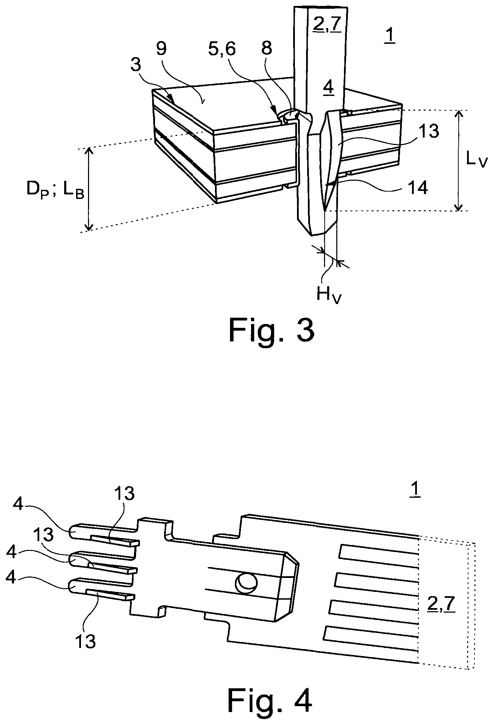

Fig. 3 shows a sectional view of the electrical heating device 1 according to the invention. In this exemplary embodiment, the at least one contact pin 4 has a radially protruding press protrusion 13. The press protrusion 13 deforms elastically at least area by area in the at least one contact bushing 4 and thus mounts the at least one contact pin 4 in the at least one contact bushing 6 by means of a radially acting pressing force. The press protrusion 13 extends axially on the at least one contact pin 4 across a length L_{V}, which is longer than the length B_{L} of the at least one contact bushing 6 and the thickness D_{P} of the control board 3. The press protrusion 13 further has a ramp area 14, which increases steadily axially from zero to a height H_{V} of the press protrusion 13. The radially acting pressing force in response to establishing the electroconductive contact between the at least one contact pin 4 and the at least one contact bushing 6 can thus increase steadily and the electroconductive contact can be established and released more easily. Moreover, the construction of the heating device 1 shown herein corresponds to the heating device 1 shown in Fig. 1.

Fig. 4 shows a partial view of the heating element 2. Here, the heating element 2 has three contact pins 4, which can be mounted in the control board 3 by means of the contact arrangement 4, as is shown in Fig. 2.

In summary, the required space for establishing the electroconductive contact between the contact pin 4 and the contact bushing 6 on the control board 3 and also in the heating device 1 can be reduced in the heating device 1 according to the invention. The heating device 1 according to the invention can thus in particular be constructed more compactly.

## Claims

1. An electrical heating device (1) comprising a heating element (2) and comprising a control board (3),
- wherein the heating element (2) is electroconductively connected to the control board (3) via at least one electrical contact pin (4),
- wherein the control board (3) has a contact arrangement (5) comprising at least one contact bushing (6), which penetrates the control board (3),
- wherein the at least one contact pin (4) penetrates the control board (3) through the at least one contact bushing (6) and is electroconductively pressure-connected to the contact bushing (6), **characterized in**
- **that** the heating element (2) is a PTC resistor heating element (7), which can be operated at a voltage of equal to 400 V or 800 V,
- **that** a length (L_{B}) of the at least one contact bushing (6) is smaller than or equal to a thickness (D_{P}) of the control board (3), and
- **that** the contact bushing (6) is arranged completely inside the control board (3).

2. The heating device according to claim 1,
**characterized in**
- **that** the at least one contact bushing (6) has a radial collar (8) each on both sides, and
- **that** the respective radial collar (8) is flush with a board surface (9) of the control board (3).

3. The heating device according to claim 1 or 2,
**characterized in**
**that** the at least one contact bushing (6) of the contact arrangement (5) and/or the at least one contact pin (4) of the heating element (2) are formed of metal, preferably of aluminum.

4. The heating device according to one of the preceding claims,
**characterized in**
- **that** the at least one contact pin (4) has at least one radially protruding press protrusion (13), and
- **that** the at least one press protrusion (13) deforms elastically at least area by area in the at least one contact bushing (6) and mounts the contact pin (4) in the contact bushing (6) by means of a radial pressing force.

5. The heating device according to one of the preceding claims,
**characterized in**
- **that** the at least one contact pin (4) has a hollow space (12), which is radially encompassed by a pressing wall (11), and
- **that** the pressing wall (11) deforms elastically at least area by area in the contact bushing (6) and mounts the at least one contact pin (4) in the contact bushing (6) by means of a radially acting pressing force.

6. The heating device according to claim 4 or 5,
**characterized in**
**that** the least one contact bushing (6) has at least one fitting molding, which is directed radially to the outside and in which at least one contact pin (4) comprising the press protrusion (13) and/or comprising the pressing wall (11), is mounted in a positive manner at least area by area.

7. The heating device according to one of the preceding claims,
**characterized in**
**that** the contact arrangement (5) has a plurality of conductor tracks (10), which are electroconductively connected to the at least one contact bushing (6) and by means of which the at least one contact bushing (6) can be electroconductively connected to control elements of the control board (3).

8. The heating device according to claim 7,
**characterized in**
- **that** the conductor tracks (10) of the contact arrangement (5) are integrated into the control board (3) and are enclosed by the latter at least area by area, and/or
- **that** the conductor tracks (10) of the contact arrangement (5) are mounted to the control board (3).

9. The heating device according to claim 7 or 8,
**characterized in**
**that** that the plurality of conductor tracks (10) of the contact arrangement (5) are formed of metal, preferably of aluminum.

## Patentansprüche

1. Elektrische Heizvorrichtung (1), umfassend ein Heizelement (2) und umfassend:
eine Steuerplatine (3),
- wobei das Heizelement (2) elektrisch leitend mit der Steuerplatine (3) über mindestens einen elektrischen Kontaktstift (4) verbunden ist,
- wobei die Steuerplatine (3) eine Kontaktanordnung (5) aufweist, die mindestens eine Kontaktbuchse (6) umfasst, welche die Steuerplatine (3) durchdringt,
- wobei der mindestens eine Kontaktstift (4) die Steuerplatine (3) durch die mindestens eine Kontaktbuchse (6) durchdringt und mit der Kontaktbuchse (6) elektrisch leitend druckverbunden ist, **dadurch gekennzeichnet, dass**
- das Heizelement (2) ein PTC-Widerstandsheizelement (7) ist, das mit einer Spannung gleich 400 V oder 800 V betreibbar ist,
- eine Länge (LB) der mindestens einen Kontaktbuchse (6) kleiner als oder gleich einer Dicke (DP) der Steuerplatine (3) ist, und
- die Kontaktbuchse (6) vollständig innerhalb der Steuerplatine (3) angeordnet ist.

2. Heizvorrichtung nach Anspruch 1,
**dadurch gekennzeichnet, dass**
- die mindestens eine Kontaktbuchse (6) beidseitig je einen radialen Bund (8) aufweist, und
- der jeweilige radiale Bund (8) bündig mit einer Platinenoberfläche (9) der Steuerplatine (3) abschließt.

3. Heizvorrichtung nach Anspruch 1 oder 2,
**dadurch gekennzeichnet, dass**
die mindestens eine Kontaktbuchse (6) der Kontaktanordnung (5) und/oder der mindestens eine Kontaktstift (4) des Heizelements (2) aus Metall, vorzugsweise aus Aluminium, gebildet sind.

4. Heizvorrichtung nach einem der vorstehenden Ansprüche,
**dadurch gekennzeichnet, dass**
- der mindestens eine Kontaktstift (4) mindestens einen radial vorstehenden Druckvorsprung (13) aufweist und
- der mindestens eine Druckvorsprung (13) sich in der mindestens einen Kontaktbuchse (6) zumindest bereichsweise elastisch verformt und den Kontaktstift (4) mittels einer radialen Druckkraft in der Kontaktbuchse (6) montiert.

5. Heizvorrichtung nach einem der vorstehenden Ansprüche,
**dadurch gekennzeichnet, dass**
- der mindestens eine Kontaktstift (4) einen Hohlraum (12) aufweist, der radial von einer Druckwand (11) umschlossen ist, und
- sich die Druckwand (11) in der Kontaktbuchse (6) zumindest bereichsweise elastisch verformt und den mindestens einen Kontaktstift (4) mittels einer radial wirkenden Druckkraft in der Kontaktbuchse (6) montiert.

6. Heizvorrichtung nach Anspruch 4 oder 5,
**dadurch gekennzeichnet, dass**
die mindestens eine Kontaktbuchse (6) mindestens eine radial nach außen gerichtete Passausformung aufweist und in der mindestens ein Kontaktstift (4), umfassend den Druckvorsprung (13) und/oder umfassend die Druckwand (11) zumindest bereichsweise formschlüssig montiert ist.

7. Heizvorrichtung nach einem der vorstehenden Ansprüche,
**dadurch gekennzeichnet, dass**
die Kontaktanordnung (5) eine Vielzahl von Leiterbahnen (10) aufweist, die mit der mindestens einen Kontaktbuchse (6) elektrisch leitend verbunden ist und mittels derer die mindestens eine Kontaktbuchse (6) elektrisch leitend mit Steuerelementen der Steuerplatine (3) verbindbar ist.

8. Heizvorrichtung nach Anspruch 7,
**dadurch gekennzeichnet, dass**
- die Leiterbahnen (10) der Kontaktanordnung (5) in die Steuerplatine (3) integriert und von dieser zumindest bereichsweise umschlossen sind und/oder
- die Leiterbahnen (10) der Kontaktanordnung (5) an der Steuerplatine (3) montiert sind.

9. Heizvorrichtung nach Anspruch 7 oder 8,
**dadurch gekennzeichnet, dass**
die Vielzahl von Leiterbahnen (10) der Kontaktanordnung (5) aus Metall, vorzugsweise aus Aluminium, gebildet ist.

## Revendications

1. Dispositif de chauffage électrique (1) comprenant un élément chauffant (2) et comprenant une carte de commande (3),
- dans lequel l'élément chauffant (2) est connecté de manière électroconductrice à la carte de commande (3) par l'intermédiaire d'au moins une broche de contact électrique (4),
- dans lequel le tableau de commande (3) présente un agencement de contact (5) comprenant au moins une douille de contact (6), qui pénètre dans la carte de commande (3),
- dans lequel l'au moins une broche de contact (4) pénètre dans la carte de commande (3) à travers l'au moins une douille de contact (6) et est connectée par pression électroconductrice à la douille de contact (6), **caractérisé en ce**
- **que** l'élément chauffant (2) est un élément chauffant à résistance PTC (7), qui peut fonctionner à une tension égale à 400 V ou 800 V,
- **qu'**une longueur (LB) de l'au moins une douille de contact (6) est inférieure ou égale à une épaisseur (DP) de la carte de commande (3), et
- **que** la douille de contact (6) est agencée entièrement à l'intérieur de la carte de commande (3).

2. Dispositif de chauffage selon la revendication 1,
**caractérisé en ce**
- **que** l'au moins une douille de contact (6) présente un collet radial (8) chaque des deux côtés, et
- **que** le collet radial respectif (8) est aligné avec une surface de carte (9) de la carte de commande (3).

3. Dispositif de chauffage selon la revendication 1 ou 2,
**caractérisé en ce**
**que** l'au moins une douille de contact (6) de l'agencement de contact (5) et/ou l'au moins une broche de contact (4) de l'élément chauffant (2) sont en métal, de préférence en aluminium.

4. Dispositif de chauffage selon l'une quelconque des revendications précédentes,
**caractérisé en ce**
- **que** l'au moins une broche de contact (4) présente au moins une saillie de pression (13) faisant saillie radialement, et
- **que** l'au moins une saillie de pression (13) se déforme élastiquement au moins zone par zone dans l'au moins une douille de contact (6) et monte la broche de contact (4) dans la douille de contact (6) au moyen d'une force de pression radiale.

5. Dispositif de chauffage selon l'une quelconque des revendications précédentes,
**caractérisé en ce**
- **que** l'au moins une broche de contact (4) présente un espace creux (12), qui est entouré radialement par une paroi de pression (11), et
- en ce que la paroi de pression (11) se déforme élastiquement au moins zone par zone dans la douille de contact (6) et monte l'au moins une broche de contact (4) dans la douille de contact (6) au moyen d'une force de pression agissant radialement.

6. Dispositif de chauffage selon la revendication 4 ou 5,
**caractérisé en ce**
**que** l'au moins une douille de contact (6) présente au moins un moulage ajusté qui est dirigé radialement vers l'extérieur et dans lequel au moins une broche de contact (4) comprenant la saillie de pression (13) et/ou comprenant la paroi de pression (11) est montée de manière positive au moins zone par zone.

7. Dispositif de chauffage selon l'une quelconque des revendications précédentes,
**caractérisé en ce**
**que** l'agencement de contact (5) présente une pluralité de pistes conductrices (10) qui sont connectées de manière électroconductrice à l'au moins une douille de contact (6) et au moyen desquelles l'au moins une douille de contact (6) peut être connectée de manière électroconductrice à des organes de réglage de la carte de commande (3).

8. Dispositif de chauffage selon la revendication 7,
**caractérisé en ce**
- **que** les pistes conductrices (10) de l'agencement de contact (5) sont intégrées dans la carte de commande (3) et sont entourées par cette dernière au moins zone par zone, et/ou
- **que** les pistes conductrices (10) de l'agencement de contact (5) sont montées sur la carte de commande (3).

9. Dispositif de chauffage selon la revendication 7 ou 8,
**caractérisé en ce**
**que** la pluralité de pistes conductrices (10) de l'agencement de contact (5) sont en métal, de préférence en aluminium.
